# EUROPEAN PATENT APPLICATION

(11) **EP 1 465 012 A2**
(43) Date of publication of application: **06.10.2004**
(21) Application number: 04076024.1
(22) Date of filing: 30.03.2004
(51) Int. Cl.: G03F 7/20

(54) **Supporting structure for use in a lithographic apparatus**

(30) Priority: 23.07.2003 EP 03077320; 31.03.2003 EP 03075929
(71) Applicant: ASML Netherlands B.V., 5504 DR Veldhoven (NL)
(72) Inventor: Tinnemans, Patricius Aloysius Jacobus, 5527 GR Hapert (NL); Buis, Edwin Johan, 5951 GZ Belfeld (NL); Donders, Sjoerd Nicolaas Lambertus, 5211 HN 's-Hertogenbosch (NL); Van Elp, Jan, 2613 RM Delft (NL); Hoogkamp, Jan Frederik, 4811 RZ Breda (NL); Van Meer, Aschwin Lodewijk Hendricus Johannes, 4703 NE Rosendaal (NL); Smulders, Patrick Johannes Cornelus Hendrik, 5685 DC Best (NL); Spanjers, Franciscus Andreas Cornelis Johannes, 5688 ED Oirschot (NL); Vermeulen, Johannes Petrus Martinus Bernardus, 5551 AV Valkenswaard (NL); Visser, Raimond, 5685 EK Best (NL); Tegenbosch, Henricus Gerardus, 5652 VC Eindhoven (NL); Van den Berg, Johannes Charles Adrianus, 4841 CE Prinsenbeek (NL); Van de Sande, Henricus Johannes Adrianus, 5663 JZ Geldrop (NL); Vervoort, Thijs, 5611 VW Eindhoven (NL)
(74) Representative: van Westenbrugge, Andries

(57) **Abstract**

The present invention relates to a lithographic projection apparatus with a supporting structure to support and move an object, like a substrate (W). The supporting structure may be a robot (8). The robot (8) has a robot arm (10) with a support frame (18) for supporting, e.g. the substrate (W). The support frame (18) has one or more clamps (20, 22, 24) for holding the object (W) during movement. The robot arm comprises one or more compliant parts (14; 26; 28). The clamp may be a Johnson-Raybeck effect type clamp with an oxidized upper surface. For better de-clamping, a RF AC decaying de-clamping voltage may be provided to the clamp. The apparatus may be cleaned with one single substrate only.

## Description

The present invention relates to a supporting structure for supporting and moving objects in a lithographic apparatus.

First of all, some definitions as used in the present description will be given.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described here above, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection systems, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other table(s) is (are) being used for exposures. Dual stage lithographic apparatus are described, for example, in US 5,969,441 and WO 98/40791, both incorporated herein by reference.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

In a lithographic apparatus, one or more actuators with grippers or clamping units, like robots, pre-aligners or substrate table pins will be used to hold and move objects from one location to another location. Those objects may be substrates, like wafers, but may also be other items.

For instance, substrates are typically introduced into a lithographic apparatus and finally placed on a substrate table. During this movement, the substrate may be handed over from a robot to a stationary position (or, optionally, to another robot). During hand-over, there may be a global tilt (for instance, 3 mrad) relative to a predetermined x-axis or y-axis, defined as Rx and Ry, respectively. This global tilt between these two items involved in a take-over should be minimized to ensure the proper working of a clamping device used by the robot to clamp, e.g., the substrate. Correct functioning of the clamping device is necessary to ensure positive handling, i.e., at every point in time, it must be unambiguous where the substrate is in the lithographic apparatus. This implies that the substrate must be actively clamped at all times.

An object of the present invention is to provide improved compensation of tilt and/or displacement between an object and a supporting structure, such as a robot arm.

To that end, a supporting structure for holding and moving an object in a lithographic apparatus is provided, the supporting structure comprising a clamp for clamping the object and being provided with a compliant part.

By the above-referred supporting structure, very accurate take-over is possible while no rotation or displacement of, e.g., a substrate is necessary. Forces created by a collision between, e.g., a substrate and a receiving supporting structure are absorbed by the compliant part. There will be less risk of displacement and of losing substrates in the lithographic apparatus.

The invention also relates to a supporting structure where the supporting structure is a robot arm. Moreover, the invention relates to a robot for use in a lithographic projection apparatus, comprising such a robot arm.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

Embodiments of the invention will now be described, by way of example only, with reference to the accompanying schematic drawings in which corresponding reference symbols indicate corresponding parts, and in which:
- Figure 1 depicts a lithographic projection apparatus according to an embodiment of the invention;
- Figure 2 schematically depicts a part of a lithographic apparatus in which the present invention can be used according to an embodiment of the invention; and
- Figure 3a schematically shows a robot arm supporting a substrate;
- Figure 3b shows a side view of the arrangement according to Figure 3a;
- Figure 4a shows a side view of a support frame of a robot arm with a clamp to hold a substrate according to an embodiment of the invention;
- Figure 4b shows a side view of a support frame of a robot arm with a clamp to hold a substrate according to an embodiment of the invention, wherein the substrate is warped;
- Figure 4c shows a cross section of a supporting structure in the form of a moveable rod with a compliant part according to an embodiment of the invention;
- Figure 4d shows a cross section of the rod of Figure 4c;
   Figures 4e and 4f show a further embodiment of a flexible supporting structure;
- Figure 5 shows a side view of a support frame of a robot arm with a clamp to hold a substrate, the clamp being provided with an oxidized upper surface according to an embodiment of the invention;
- Figure 6a shows a side view of a support frame with a clamp to hold a substrate, the clamp being a Johnson-Raybeck type clamp according to an embodiment of the invention;
- Figure 6b shows an enlarged portion of the clamp of Figure 6a;
- Figure 7 shows a de-clamping voltage provided to a Johnson-Raybeck type clamp in accordance with an embodiment of the invention;
- Figure 8 shows a substrate table with an actuator to lift and lower a substrate from and towards the substrate table according to an embodiment of the invention.

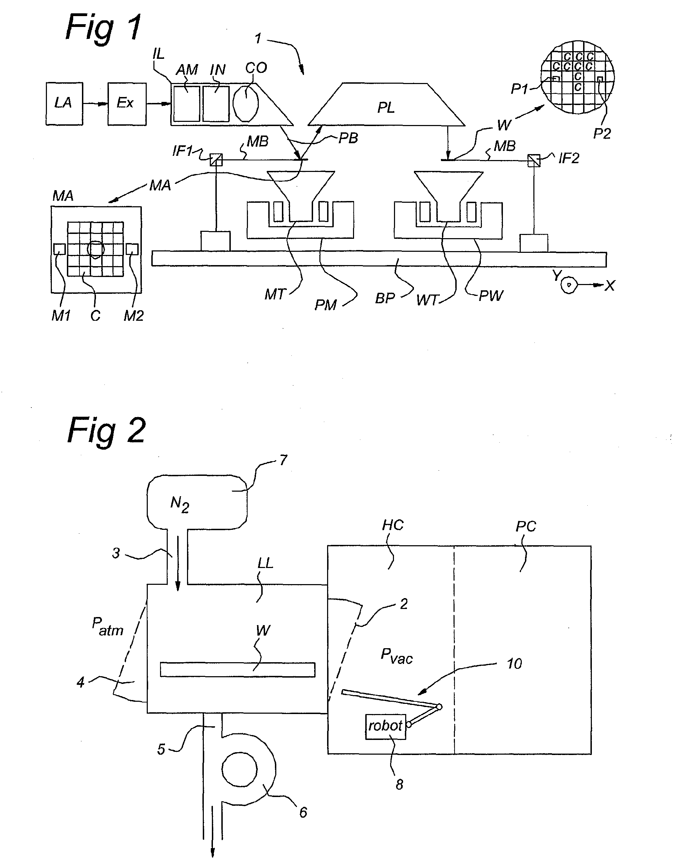

Figure 1 schematically depicts a lithographic projection apparatus 1 according to a particular embodiment of the invention. The apparatus comprises:
- a radiation system Ex, IL, for supplying a projection beam PB of radiation (e.g. EUV radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL (e.g. mirrors for EUV radiation) for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example with a transmissive mask. Alternatively, the apparatus may employ another kind of patterning means, such as a programmable mirror array of a type as referred to above.

The source LA (e.g. EUV source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1.

However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Figure. 2 schematically depicts several parts of the lithographic apparatus through which, in operation, substrates (and possibly other objects) may be moved. Figure 2 shows a load lock LL, a handling chamber HC and a projection chamber PC. The load lock LL comprises two doors 2, 4. The first door 2 faces the inside of the lithographic projection apparatus 1, comprising the handling chamber HC and the projection chamber PC, in which, in an embodiment, vacuum conditions, having a pressure P_{vac}, are maintained. The second door 4 faces, e.g., atmospheric conditions, having a pressure that is, for instance, equal to atmospheric pressure Pₐₜₘ. However, the invention can also advantageously be applied for other pressure values.

The load lock LL comprises a wall that forms an inner space. The load lock LL is further provided with supporting means (not shown) for supporting one or more objects, such as a substrate (wafer) W, as will be known to a person skilled in the art.

As can be seen in Figure. 2, the load lock LL is also provided with a gas inlet 3 and a gas outlet 5. The gas outlet 5 can be provided with a pump 6 to pump down the load lock LL to vacuum conditions of, for instance, 10⁻³ - 10⁻⁵ Pa, a pressure substantially equal to or lower than P_{vac}. The movement of, for instance, a substrate W from the atmospheric environment to the vacuum via the load lock LL, usually comprises the following steps:
- opening the second door 4 facing the atmospheric conditions Pₐₜₘ,
- transferring the substrate W from atmospheric conditions Pₐₜₘ into the load lock LL,
- closing the second door 4,
- depressurizing the load lock LL to a pressure substantially equal to or less than vacuum conditions P_{vac} through gas outlet 5 using, for example, pump 6,
- opening the first door 4 facing the vacuum conditions P_{vac}, and
- transferring the substrate W to the vacuum conditions P_{vac} from the load lock LL.

The gas inlet 3 can be used to vent the load lock in order to raise the pressure in the load lock from P_{vac} to Pₐₜₘ. Movement of a substrate W from the vacuum to the atmospheric environment via the load lock LL, usually comprises the following steps:
- depressuring the load lock LL to a pressure substantially equal to or less than the vacuum conditions P_{vac},
- opening the first door 2 facing the vacuum conditions P_{vac},
- transferring the substrate W from the vacuum conditions P_{vac} into the load lock LL,
- closing the first door 2,
- venting the load lock LL to a pressure substantially equal to or more than atmospheric conditions Pₐₜₘ via the gas inlet 3,
- opening the second door 4 facing the atmospheric conditions P_{atm;} and
- delivering the substrate W to the atmospheric conditions Pₐₜₘ.

These actions as listed above refer to atmospheric conditions outside the first door 2. However, as is known to persons skilled in the art there may be other pressure conditions outside the load lock. The example given above is by no means intended to restrict the use of the load lock LL. Hazardous particles and contaminating molecules, such as oxygen, hydrocarbons and/or H₂O that may interfere with processes in the lithographic projection apparatus, are limited from entering the load lock LL by filling the load lock LL with a specially chosen gas that doesn't comprise these particles or molecules. Gasses, such as N₂ gas, Ar gas or synthetic air, but of course also other suitable gasses, can be used, as will be understood by a person skilled in the art.

When the load lock LL is brought back from P_{vac} to Pₐₜₘ by supplying gas through gas inlet 3 to the load lock LL a special gas is typically used instead of normal environmental air. Figure. 2 shows a gas supply 7 comprising N₂ gas. Gas supply 7 may be a high pressure tank.

It will be appreciated by persons skilled in the art that for supporting and moving a substrate W, and possibly other objects in, towards and from the lithographic apparatus (like in a track, the load lock, a pre-aligner and the projection chamber), use is made of a supporting structure driven by an actuator to move the substrate W in either one, two or three dimensions, such as a robot 8 with an arm provided with a suitable gripper or clamp. Another example of a supporting structure is pins to displace, lift or lower a substrate in a direction, which are, optionally, provided with aclamp to hold the substrate In the embodiments described below, reference will be made to substrates, but the invention is equally applicable to other objects.

### Embodiment 1

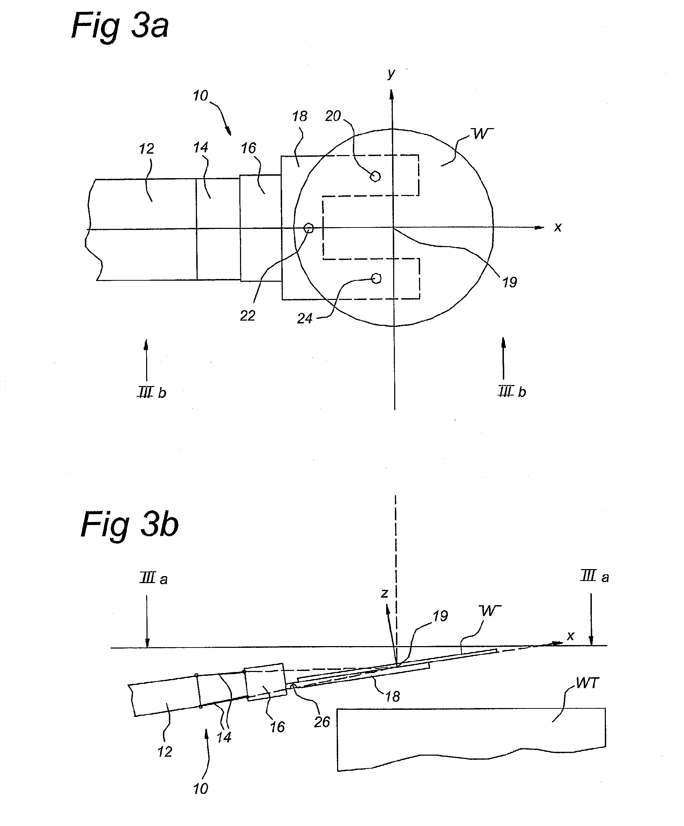

Figure 3a shows a robot arm 10 of robot 8 in more detail. The robot arm 10 comprises a rod 12 connected to a support frame 18 by means of a compliant part 14 and an intermediate part 16.

As shown, the support frame 18 is provided with three clamps 20, 22, and 24. The support frame 18 supports a substrate W. The substrate W can be held on the support frame 18 by means of the clamps 20, 22 and 24.

The support frame 18 defines a plane in which the substrate W lies when it is clamped by the clamps 20, 22, and 24. That plane is defined by an x-axis and an y-axis. The x-axis is in the longitudinal direction of the rod 12, whereas the y-axis is perpendicular to the x-axis. A z-axis is defined perpendicular to both the x-axis and the y-axis. The z-axis is not shown in Figure 3a but is shown in Figure 3b. The x-, y- and z-axes have an origin 19 that is defined to be the location where the center of the substrate W is to be substantially located during movement of the substrate W through the apparatus shown in figure 2.

Figure 3b shows a side view of the arrangement shown in Figure 3a. Figure 3b, additionally, shows the substrate table WT (which is not shown in Figure 3a). Moreover, Figure 3b shows that support frame 18 may be provided with a compliant portion (or flexible portion) 26. The compliant portion 26 may be located behind the "fingers" of support frame 18 but may also be located within one or both of the "fingers".

As shown in Figure 3b, the compliant portion 14 may comprise two or more compliant rods 14, rotatable at their ends. Thus, the intermediate part 16 is able to rotate slightly about both the x-axis and the y-axis. Moreover, it can be lifted slightly in the z-direction. Of course, the compliant portion 14 can be made of any other structure or of any material, having a flexible or compliant feature.

As shown in Figure 3b, the compliant portion 26 of the support frame 18 is produced by providing the support frame 18 with a notch, such that the front side of the support frame designed to hold the substrate W is allowed to rotate about both the x-axis and the y-axis, and to lift slightly in the z-direction, without any movement of the rod 12.

Preferably, the compliant portion 14 is designed such that it has rotation poles in a predetermined center coinciding with the center of the coordinate system, as defined by the x-, y- and z-axes. This point of origin is also the location where the center of the substrate W is to be located during gripping/clamping by the robot arm. Thus, any rotation errors in a positive and negative direction of the substrate W about the x- and/or y-axis (generally a tilt) can be adapted best.

By providing the robot arm 10 with at least one of the compliant parts 14, 26, a tilt and/or a displacement in z between the substrate W and another part in the lithographic apparatus can be compensated. This is for instance significant during substrate hand-over from a substrate handler robot to the substrate table WT and from a pre-aligner to a substrate handler robot. However, this also holds for other hand-overs in the apparatus. It is especially important for the hand-over to a device provided with clamps to hold, e.g., the substrate W. If the tilt and/or a displacement in z between the substrate W and the part to receive the substrate W is too large, the hand-over cannot take place because the clamps may not function. By providing the compliant parts 14 or 26, small tolerances are introduced enabling, in this case, the substrate W to adapt its tilt and/or a z-displacement to the other receiving part under a small force.

European Patent Application 03075929.4 of the present applicant, from which the priority is claimed and which is incorporated herein in its entirety, discloses that a compliant mechanism is also provided between the gripper and the armset (as described in EP 03075929.4), to decouple the movements of the gripper with respect to the armset. As a result of the mechanical link, the accuracy of the position of the gripper, and thus the substrate, with respect to the receiver is increased. Also, vibrations, and in particular the relative vibrations of the gripper and the receiver are reduced and the mutual accuracy of the substrate and the receiver can be increased. Of course, the mechanical docking solution can also be used for the reverse procedure, i.e. picking up objects, as for instance a substrate, from the receiver.

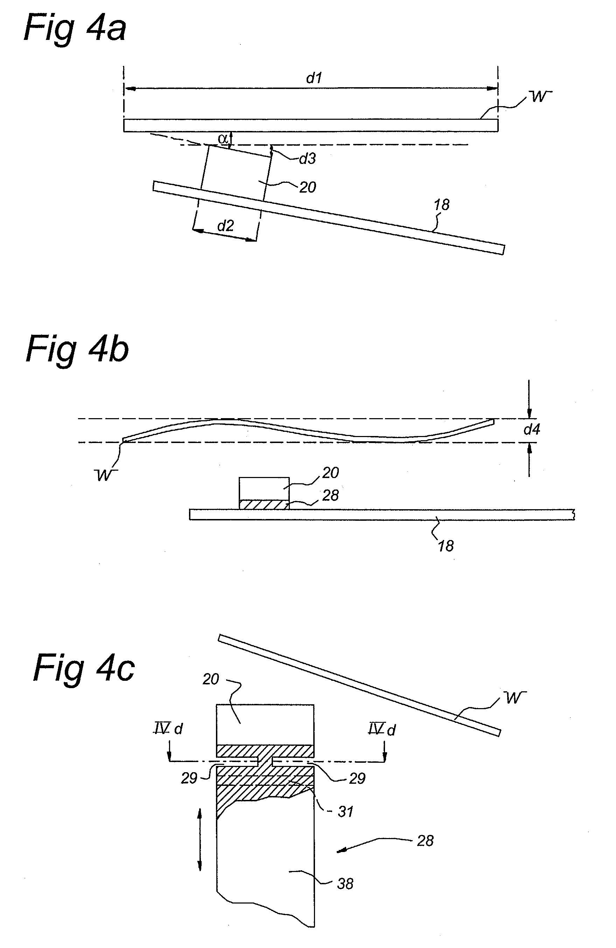

Figures 4a and 4b show that the provision of compliant parts within a clamp may also help correcting for tilt and displacements when clamping a substrate W (or any other object) to a clamp on a support frame 18 of a robot arm.

Figure 4a shows the support frame 18 provided with the clamp 20, approaching a substrate W to be clamped. There is a tilt angle α between the top of the clamp 20 and the substrate W. The substrate W has a diameter D1 that may be 200 mm. The clamp 20 has a diameter D2 that may be 40 mm. In an example, for a proper clamp functioning, the tilt angle α requirements can be so low that the distance indicated by D3 in Figure 4a needs to be below 8 micrometers. The clamping device may be a vacuum pad or an electrostatic clamp, like a Johnson-Raybeck effect clamp. As is known to persons skilled in the art, tilt requirements are more stringent for the electrostatic clamps.

Figure 4b shows that the substrate W may not be perfectly flat in a plane but may, e.g., be undulated when viewed in cross-section. The undulation amplitude D4 may be as large as 500 micrometer. This undulation may be the result of all kinds of process steps during the lithography process, as is known to persons skilled in the art. Due to the undulated cross-section of the substrate W, the stringent tilt requirements may not be met at all locations of the substrate W.

To compensate then for a tilt and/or displacement between the substrate and the clamp, the clamp 20 may be provided with a compliant portion 28 as shown in Figure 4b. This compliant portion 28 may be made of a metal flexure or any other flexible material or structure suitable for a lithographic projection apparatus. The compliant portion 28 provides the clamp with Rx, Ry, and z compliance. Either the weight of the substrate W or a small positive force in the z-direction used during hand-over of the substrate W may, then, ensure that the surface of the clamp will align with the rear surface of the substrate W. When aligned, the clamp 20 will hold the rear surface of the substrate W. The clamp force will then be sufficient to keep the substrate W clamped during movement through the apparatus. The clamp compliance can be made such that the substrate's x, y and Rz position are not changed. This maintains positional accuracy of the substrate, as is required for other processes in the lithographic projection apparatus.

Preferably, the weight of the substrate W is sufficient to align the clamp since the clamp should also work after losing clamp force due to, e.g., cut off of electrical power, after an emergency stop of the apparatus, etc.

As may be evident to a person skilled in the art, the compliant portion 28 can also correct for any curvature of the support frame 18.

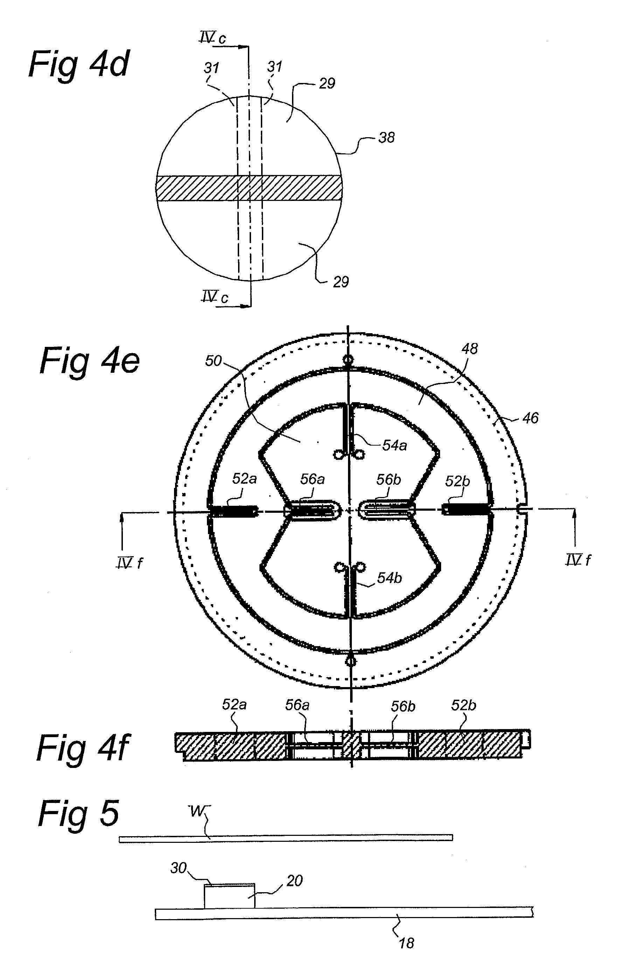

Figures 4c and 4d show the provision of compliant portions with supporting structures that are allowed to move in one direction only. The supporting structure shown comprises a rod like a substrate table pin 38 having a clamp 20 mounted on an end. The pin 38 comprises compliant portion 28. The compliant portion 28 is made by providing the pin with two notches 29 that provide the pin 38 with a flexibility in a first direction perpendicular to its direction of movement. There may be provided two other notches 31, as indicated with dashed lines, in the pin 38 perpendicular to the notches 29 to provide the pin 38 with a flexibility in a second direction perpendicular to the first direction.

Figure 4d shows a cross section of the pin of Figure 4c in the direction of Nd-Nd, as shown in Figure 4c to better show the notches 29 and optional notches 31.

Of course, other compliant parts than the one shown in Figures 4c and 4d can be used. The rod 38 may a cross section different from the circular one shown.

A further embodiment of a flexible supporting structure to be used with, e.g., an electrostatic clamp for clamping, e.g., a wafer or a reticle, is shown in figures 4e and 4f.

The supporting structure shown comprises an outer ring 46, an interface ring 48 and a central part 50. The outer ring 46 will be fixed in a gripper (not shown) or a stage (not shown). On top of the central part 50, an electrostatic clamp (not shown) will be attached, e.g., by glueing. In the outer ring 46, the interface ring 48 is fixed with two leaf springs 52a and 52b releasing the y, Rx and Rz d.o.f.'s (= degrees of freedom). The central part 50 on its turn is fixed to the interface ring 48 by two leaf springs 54a, 54b and two rods 56a, 56b. The leaf springs 54a, 54b are oriented to block the Rx d.o.f. Thus, together with the rods 56a, 56b the arrangement is such that the interface ring with respect to the central part 50 releases only one rotation, i.e., Ry. Two remaining translations are fixed with the flexible supporting structure of Figures 4e and 4f, i.e., x and z d.o.f.'s.

### Embodiment 2

Figure 5 shows a further embodiment of the invention, in which the clamp 20 on the support frame 18 is a Johnson-Raybeck effect type clamp. As known to persons skilled in the art, a Johnson-Raybeck effect type clamp is provided with a dielectric material made from a very low conductive material. Due to the very low conductivity (of electrical resistance) ofthe dielectric material, electrical clamping charges migrate through the dielectric material towards the clamping surface. In use, contact with substrate W is only made at some tiny spots. Between those tiny spots there are "open" spaces defining a distance between the clamping surface and the rear side of substrate W. Charges opposite the "open" spaces in both the clamping surface and the substrate W create a clamp with a very small distance between the charges, only the remaining gap, and hence create very large clamping forces.

In a Johnson-Raybeck clamp a small electrical current is flowing through the dielectric layer (furthermore in this example a small current flows in between the wafer and the dielectric material), which leads to a relatively small heat load of the combined clamp substrate system. For most applications this is not a problem because of the absence of lithography requirements like overlay and critical dimensions. For a clamp to be used in a lithography tool this can be a problem.

A solution to that problem according to an embodiment of the invention is to provide the upper surface of the clamp 20 a high electrical resistance coating (for example a thin dielectrical layer of several (1-20) microns) such as an oxidized layer 30 (for example SiO2), as shown in Figure 5. This oxidized layer 30 may be provided to the clamp 20 in any way known to persons skilled in the art. By providing the clamp 20 with the oxidized layer 30, only a very small electrical current will flow in the contact area between the clamp and the substrate and into the substrate W itself, thus having a negligible impact on the temperature of the substrate W.

### Embodiment 3

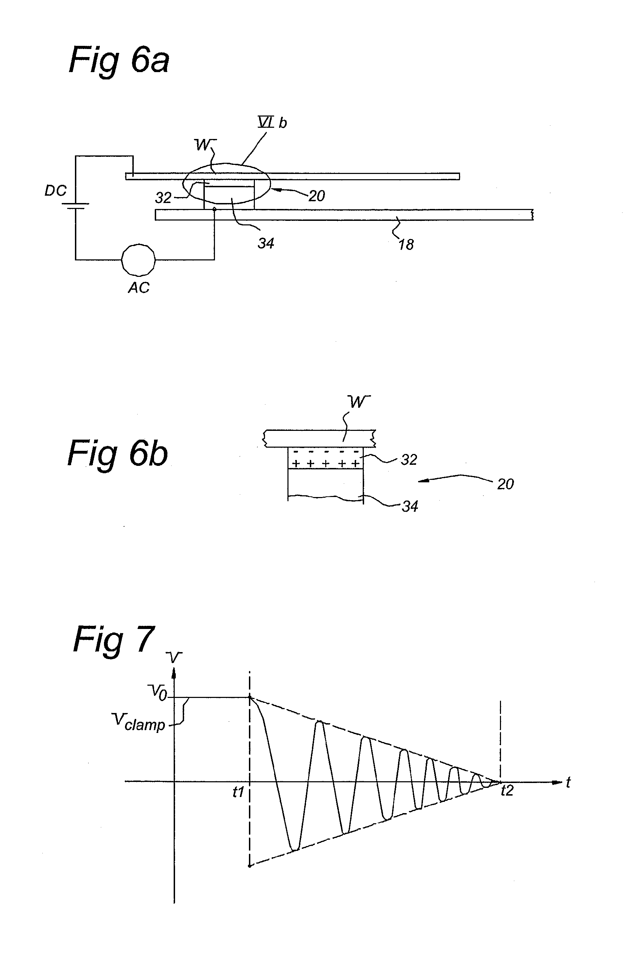

Figure 6a shows the support frame 18 provided with the clamp 20, the clamp 20 being a Johnson-Raybeck effect clamp. The clamp 20 holds the substrate W. The clamping effect is generated by a controller, shown as a series connection of a DC voltage source and an AC voltage source. As will be appreciated by a person skilled in the art, the controller may be based on any suitable electronic circuit or may be implemented by a computer.

Figure 6b shows a portion of Figure 6a on an enlarged scale. Figure 6b shows that the Johnson-Raybeck effect type clamp 20 is provided with a conductive part 34 and a electrically leaky insulator 32. Due to the leaky insulator 32, an electrical current will flow between the conductor part 34 and the substrate W resulting in trapped charges in the leaky insulator 32.

For clamping the substrate W to the clamp 20, only the DC source is switched on and the AC source is switched off. To de-clamp the substrate W from the clamp 20, one can simply switch off the DC source. However, due to the trapped charges in the leaky insulator 32, it will take a while before the attracting force between the clamp 20 and the substrate W is small enough to remove the substrate W. This is due to the trapped charges in the leaky insulator 32 only leaking away from the leaky insulator 32 very slowly.

It is known to solve this problem by applying one or more reverse-polarity voltage steps, opposite of the clamping potential provided by the DC source.

However, an alternative solution is for the AC source to be is arranged to provide a decaying AC voltage from the time that de-clamping starts. This is further explained in Figure 7. Figure 7 shows that the clamping voltage V_{clamp} has a predetermined value V₀ at the time of clamping. At time t₁, the substrate W is to be de-clamped from the clamp 20. Then, at time t₁, the DC source is switched off and the AC source is switched on such that an AC voltage with decaying amplitude is provided to the clamp 20 until the amplitude of the AC voltage is substantially zero at time t₂. Preferably, the frequency of the AC source is a radio frequency. At time t₂, the clamping force of the clamp 20 is so small that the substrate W can be safely removed from the clamp 20.

### Embodiment 4

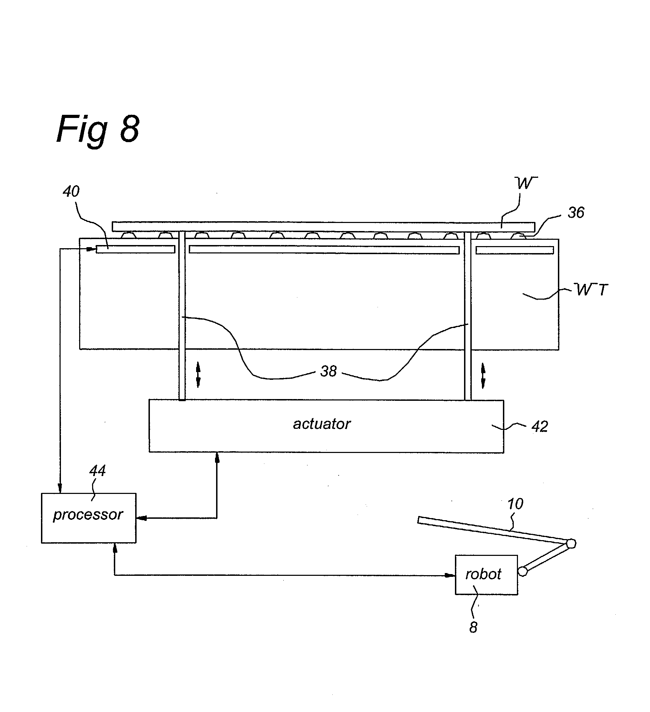

Figure 8 shows the substrate table WT with the substrate W on it.

The lithographic apparatus is provided with an actuator 42 provided with pins 38. In use, the actuator 42 is arranged to displace the substrate W from and towards the substrate table WT. The substrate table WT is provided with a substrate support 36 (such as pimples) for supporting the substrate W. By providing the substrate table WT with the substrate support 36, the actual surface of contact between the substrate table WT and the substrate W is reduced while still providing a proper support.

The substrate table WT is provided with a clamp 40, e.g., an electrostatic clamp or vacuum clamp. However, other types of clamps may be used as well, as is known to persons skilled in the art.

A processor 44 is provided that is connected to both the clamp 40 and the actuator 42, in order to provide them with suitable control signals.

The robot 8 with its robot arm 10 is shown again, together with its connection to the processor 44, such that the processor 44 can also control the operation of the robot 8.

Sometimes, substrate cycling is part of a substrate table cleaning procedure. After a chemical and/or mechanical cleaning part of this procedure, typically about 8 substrates are cycled successively onto the substrate table to remove remaining contaminants from the substrate support 36 and to reach a substrate rear side contamination specification again. However, there are at least two problems related to this current cleaning procedure:
1. availability and cost of the required number (8) of clean substrates at customer locations for substrate cycling;
2. downtime of the apparatus because of cycling cleaning substrates.

In accordance with an embodiment of the invention, the number of substrates needed for substrate cycling is drastically reduced to one single substrate. To that end, the processor 44 is arranged to control the clamp 40, the actuator 42 and the robot 8 in the following way:
- introducing the substrate W in the lithographic projection apparatus by means of the robot 8;
- clamping the substrate W to the substrate table WT by means of the clamp 40, such that the substrate W contacts the substrate table WT at a first location;
- de-clamping the substrate W from the substrate table WT by providing a de-clamping voltage to the clamp 40;
- repeating the clamping and de-clamping a predetermined number of times, such that the substrate contacts the substrate table WT repeatedly, either at a first location or at other locations than the first location.

In order to be sure that successive other locations of contacts with the substrate are arranged by which contamination will be removed from the substrate support 36, preferably, the actuator 42 is arranged to displace the substrate W from the substrate support 36 after de-clamping, to have the robot 8 rotate or shift the substrate W, to displace the substrate W to the substrate support 36 to clamp the substrate W by the clamp 40 again, etc. This may be repeated, e.g., 8 times.

By programming the processor 44 for this proposed method, the cleaning procedure may be much faster than in the past. Moreover, only one substrate is necessary for such a cleaning procedure. Thus, several portions of the rear surface of the substrate W are used to remove contamination on the substrate support 36; thus, saving the number of substrates necessary to perform the cleaning procedure.

Whilst specific embodiments of the invention have been described above, it will be appreciated that the invention may be practiced otherwise than as described. The description is not intended to limit the invention. For instance, it will be understood that the number of robots may be more than the single robot 8 shown in the figures. Moreover, there may be more load locks than the single load lock shown.

Moreover, although a single processor 44 is shown (Figure 8), there may be more than one processor to control different components of the apparatus. These processors may be connected to one another and arranged to co-operate, e.g., in a master slave arrangement.

## Claims

1. Supporting structure for holding and moving an object in a lithographic apparatus, the supporting structure comprising a clamp for clamping said object and being provided with a compliant part.

2. Supporting structure according to claim 1, wherein said supporting structure is a robot arm for use with a robot, said robot arm comprising a support frame (18) for holding said obj ect.

3. Supporting structure according to claim 2, wherein said robot arm comprises a rod connected to said support frame (18) and comprising said compliant part (14).

4. Supporting structure according to claim 2, wherein said support frame (18) comprises said compliant part (26).

5. Supporting structure according to claim 1 or 2, wherein said clamp (20; 22; 24) comprises said compliant part (28).

6. Supporting structure according to any one of claims 2 to 5, wherein said support frame is in a plane defined by a x-axis, a y-axis, and a z-axis being perpendicular to said x-axis and said y-axis, said compliant part providing a compliance in at least one of a first rotation (Rx) about said x-axis, a second rotation (Ry) about said y-axis, and a z-direction parallel to said z-axis.

7. Supporting structure according to claim 3, wherein said compliant part is arranged such that said support frame is allowed to rotate about a predetermined center of rotation (19).

8. Johnson-Raybeck effect type clamp, having an upper surface for clamping an object in a lithographic projection apparatus, the upper surface being provided with an oxidized layer (30).

9. Supporting structure for holding and moving objects in a lithographic projection apparatus, comprising at least one Johnson-Raybeck effect type clamp (20) and a controller (DC, AC) connected to said Johnson-Raybeck effect type clamp (20) and arranged to provide a clamping and de-clamping voltage to said Johnson-Raybeck effect type clamp (20), wherein said controller is arranged to generate said de-clamping voltage with a decaying AC-profile.

10. Method of cleaning a substrate table in a lithographic projection apparatus, the substrate table (WT) comprising a clamp for clamping a substrate (W), the method comprising:
• introducing a substrate (W) in said lithographic projection apparatus;
• clamping said substrate (W) to said substrate table (WT) such that said substrate (W)
• contacts said substrate table (WT) at a first location;
• de-clamping said substrate (W) from said substrate table (WT);
• repeating said clamping and de-clamping a number of times such that said substrate contacts said substrate table (WT) repeatedly at said first location and/or at a location other than said first location.

11. Supporting structure according to any one of claims 1 to 7, and 9, arranged to hold a substrate (W).

12. Supporting structure according to any one of claims 1 to 7, 9 and 11, wherein said supporting structure comprises a rod (38) provided with said compliant part.

13. Supporting structure according to any one of claims 1-7, 9, 11 and 12, wherein said compliant portion comprises a metal flexure.

14. Supporting structure according to claim 9, wherein said predetermined decaying AC-profile is a RF AC profile.

15. Robot for use in a lithographic projection apparatus, the robot being provided with a supporting structure according to anyone of claims 1-7, 9, and 11-14.

16. A lithographic projection apparatus comprising:
- a radiation system for providing a projection beam (PB) of radiation;
- a support structure (MT) for supporting patterning means (MA), the patterning means (MA) serving to pattern the projection beam (PB) according to a desired pattern;
- a substrate table (WT) for holding a substrate (W); and
- a projection system (PL) for proj ecting the patterned beam onto a target portion (C) of the substrate (W),
**characterized in that**
the lithographic projection apparatus (1) comprises a supporting structure as claimed in any one of claims 1-7, 9, and 11-14.

17. A device manufacturing method comprising:
- providing a substrate that is at least partially covered by a layer of radiation-sensitive material;
- providing a projection beam (PB) of radiation
- using patterning means (MA) to endow the projection beam (PB) with a pattern in its cross-section; and
- projecting the patterned beam of radiation onto a target portion (C) of the layer of radiation-sensitive material,
**characterized by**
providing said substrate (W) by using a supporting structure as claimed in any oneof the claims 1-7, 9, and 11-14.

18. A lithographic projection apparatus comprising:
- a radiation system for providing a projection beam (PB) of radiation;
- a support structure (MT) for supporting patterning means (MA), the patterning means (MA) serving to pattern the projection beam (PB) according to a desired pattern;
- a substrate table (WT) holding a substrate (W); and
- a proj ection system (PL) for proj ecting the patterned beam onto a target portion (C) of the substrate (W),
- a clamp for clamping said substrate (W) and/or said patterning means (MA);
**characterized in that**
the clamp is a Johnson Raybeck effect type clamp as claimed in claim 8.

19. A device manufacturing method comprising:
- providing a substrate that is at least partially covered by a layer of radiation-sensitive material;
- providing a projection beam (PB) of radiation;
- using patterning means (MA) to endow the proj ection beam (PB) with a pattern in its cross-section; and
- projecting the patterned beam of radiation onto a target portion (C) of the layer of radiation-sensitive material,
**characterized by**
using a Johnson Raybeck effect type clamp as claimed in claim 8.

20. A lithographic projection apparatus comprising:
- a radiation system for providing a projection beam (PB) of radiation;
- a support structure (MT) for supporting patterning means (MA), the patterning means (MA) serving to pattern the projection beam (PB) according to a desired pattern;
- a substrate table (WT) holding a substrate (W); and
- a proj ection system (PL) for proj ecting the patterned beam onto a target portion (C) of the substrate (W),
**characterized in that**
• said lithographic projection apparatus comprises a robot for holding and moveing a substrate (W) in said lithographic projection apparatus;
• said lithographic projection apparatus comprises a clamp (40) for clamping said substrate (W) to said substrate table (WT) such that said substrate (W) contacts said substrate table (WT) at a first location, and a processor to instruct repeated clamping and de-clamping of said substrate , by said clamp, such that said substrate contacts said substrate table repeatedly at said first location and/or locations other than said first location in order to clean said substrate table (WT).

21. A device manufacturing method comprising:
- providing a substrate that is at least partially covered by a layer of radiation-sensitive material
- providing a projection beam (PB) of radiation;
- using patterning means (MA) to endow the projection beam (PB) with a pattern in its cross-section; and
- projecting the patterned beam of radiation onto a target portion (C) of the layer of radiation-sensitive material,
**characterized by**
using the method of claim 10 to clean the substrate table (WT).
